# EUROPEAN PATENT SPECIFICATION

(11) **EP 3 392 286 B1**
(45) Date of publication and mention of the grant of the patent: **04.11.2020**
(21) Application number: 16874598.2
(22) Date of filing: 14.09.2016
(51) Int. Cl.: C08G 59/42, C08G 59/40, C08L 63/00, C07D 519/00, C08G 59/32

(54) **EPOXY RESIN COMPOSITION AND PREPREG, LAMINATED BOARD AND PRINTED-CIRCUIT BOARD COMPRISING SAME**
EPOXIDHARZZUSAMMENSETZUNG UND PREPREG, LAMINIERTE PLATTE UND LEITERPLATTE DAMIT
COMPOSITION DE RÉSINE ÉPOXYDE ET PRÉIMPRÉGNÉ, CARTE STRATIFIÉE ET CARTE DE CIRCUIT IMPRIMÉ LA COMPRENANT

(30) Priority: 17.12.2015 CN 201510955327
(43) Date of publication of application: 24.10.2018
(73) Proprietor: Shengyi Technology Co., Ltd., Dongguan City, Guangdong 523808 (CN)
(72) Inventor: ZENG, Xianping, Dongguan City Guangdong 523808 (CN); HE, Liexiang, Dongguan City Guangdong 523808 (CN); XU, Haosheng, Dongguan City Guangdong 523808 (CN)
(74) Representative: Ricker, Mathias
(86) International application number: PCT/CN2016/099127
(87) International publication number: WO 2017/101538

(56) References cited:
- EP-A1- 2 770 005
- EP-A2- 0 347 800
- CN-A- 102 977 551
- CN-A- 103 937 157
- CN-A- 105 153 234
- JP-A- 2003 131 373
- US-A1- 2015 247 015

## Description

### Technical field

The present invention belongs to the technical field of copper clad laminates, and in particular relates to an epoxy resin composition, a prepreg, a laminate and a printed circuit board comprising the same.

### Background art

With the high-performance, high-functionalization and networking development of information communication equipments in recent years, operation signals tend to be high-frequency in order to transmit and process large-capacity information at a high speed. At the same time, in order to meet the requirements on the development trend of various electronic products, circuit boards develop in the direction of high multilayer and high wiring density. This requires that the substrate material not only has a good dielectric constant and dielectric loss factor to meet the need for high-frequency signal transmission, but also requires good heat resistance to meet the needs for reliability of multilayer printed circuit boards.

Cyanate ester has a good adhesion and processability, and a high glass transition temperature, a low dielectric constant and a low dielectric loss. However, it is prone to absorbing water, resulting in insufficient heat and moisture resistance. Thus delamination and popcorn easily occur in the application of PCB multilayer boards.

CN 101967264 A, CN 101967265 A and CN 102504201 A disclose using cyanate ester and active ester as a composite curing agent to cure biphenyl novolac epoxy resin, aralkylene epoxy resin and naphthol epoxy resin, so as to optimize heat resistance and heat and moisture resistance. CN 103304963 A solves the problem of the decrease in heat resistance or dielectric properties of plates caused by the addition of reactive phosphorus-containing flame retardants and additive flame retardants in large amounts in the above inventions. Related technologies are known from EP 2 770 005 A1 and US 2015/247015 A1.

However, there is no mention about how to solve the contradiction between heat resistance and heat and moisture resistance, and how to find a balance point among them in the above prior art, which becomes one of technical problems.

### Disclosure of the invention

For the problems of the prior art, the object of the present invention is to provide an epoxy resin composition. The prepreg, laminate, and printed circuit board prepared from the epoxy resin composition have both high heat and moisture resistance and high heat resistance. In addition, the prepreg, laminate, and printed circuit board also have a low coefficient of thermal expansion, a low water absorption rate, and excellent dielectric properties.

In order to achieve the above object, the present invention discloses the following technical solutions:
an epoxy resin composition comprising the following components:
(A) from 38 to 54 parts by weight of an epoxy resin containing a DCPD structure;
(B) from 30 to 36 parts by weight of an active ester curing agent; and
(C) from 16 to 32 parts by weight of a cyanate ester resin.

In order to achieve the object above, the inventors conducted repeated and in-depth studies, and found that the aforesaid object could be achieved by the epoxy resin composition obtained by properly mixing an epoxy resin containing a DCPD structure, an active ester curing agent and a cyanate ester resin in specific contents, and other optional components.

The present invention discloses adopting an epoxy resin containing a DCPD (dicyclopentadiene) structure in a specific content, which has a weight-average molecular weight of 200-4000 and the proportion of the weight-average molecular weight distribution of less than 400 is less than 30%wt. The epoxy resin can improve the glass transition temperature, moisture and heat resistance and reduce the water absorption rate thereof. The active ester curing agent in a specific content can improve the dielectric properties and water absorption performance of the epoxy resin composition. The cyanate ester resin in a specific content can increase the glass transition temperature of the epoxy resin composition and lower the coefficient of thermal expansion thereof. The present invention discloses obtaining the above-mentioned epoxy resin composition by utilizing the mutual cooperation and synergistic effect between the aforesaid three essential components in specific contents. Prepreg, laminate, and printed circuit board made from the epoxy resin composition have low coefficient of thermal expansion, low water absorption rate, and excellent dielectric properties, on the premise of having high heat and moisture resistance and high heat resistance at the same time.

In the present invention, the component (A) epoxy resin containing a DCPD structure can increase the glass transition temperature of the epoxy resin composition and reduce the water absorption rate thereof. The component (A) epoxy resin containing a DCPD structure is added in an amount of 38 to 54 parts by weight, e.g. 38, 40, 42, 43, 44, 46, 48, 49, 50, 51, 53 or 54 parts by weight, preferably from 45 to 54 parts by weight.

Preferably, the component (A) epoxy resin containing a DCPD structure is an epoxy resin having the structure of Formula (1) 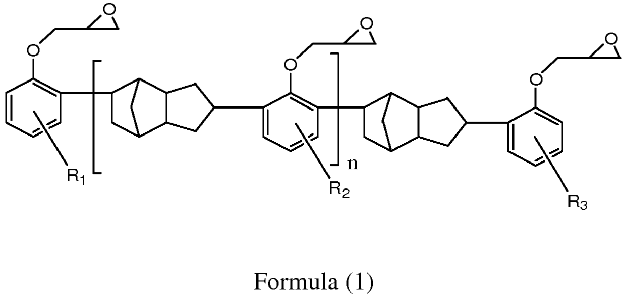 wherein R₁, R₂, and R₃ are the same or different and each independently selected from the group consisting of hydrogen atom, substituted or unsubstituted C1-C8 (e.g. C2, C3, C4, C5, C6 or C7) linear or branched alkyl group; n represents a repeating unit and is an integer greater than or equal to 1, e.g. 1, 3, 5, 8, 10 or 13; the weight-average molecular weight thereof is 200 to 4000, and the proportion of the weight-average molecular weight distribution of less than 400 is less than 30% by weight. In the present invention, the component (A) epoxy resin containing a DCPD structure satisfies the weight-average molecular weight distribution of 200-4000, and the weight-average molecular weight distribution of less than 400 has a proportion of less than 30 %wt, which can improve the moisture and heat resistance of the epoxy resin composition.

In the present invention, the component (B) active ester curing agent can improve the dielectric properties and water absorption property of the epoxy resin composition. The component (B) active ester curing agent is added in an amount of 30 to 36 parts by weight, e.g. 30, 31, 32, 33, 34, 35 or 36 parts by weight, preferably 30 to 33 parts by weight.

Preferably, the component (B) active ester curing agent is obtained by reacting a phenolic compound linked through an alicyclic hydrocarbon structure, a difunctional carboxylic aromatic compound or acid halide and a monohydroxy compound.

Preferably, the difunctional carboxylic aromatic compound or acid halide is in an amount of 1mol; the phenolic compound linked through an alicyclic hydrocarbon structure is in an amount of 0.05-0.75mol; the monohydroxy compound is in an amount of 0.25-0.95mol.

Preferably, the component (B) active ester curing agent comprises an active ester having the structure of Formula (2) 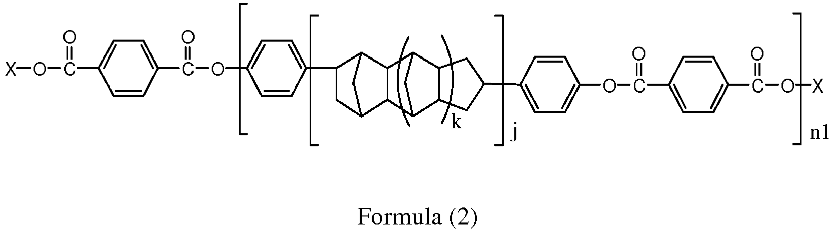 wherein X is phenyl or naphthyl; j is 0 or 1; k is 0 or 1; and n1 represents a repeating unit and is from 0.25 to 1.25.

Due to the special structure of the active ester, the rigid structures such as phenyl, naphthyl, and cyclopentadiene confer high heat resistance to the active ester, and the active ester has good dielectric properties and low water absorption rate because of its structural regularity and no production of secondary hydroxyl groups during the reaction with the epoxy resin.

In the present invention, the component (C) cyanate ester resin can greatly increase the glass transition temperature of the epoxy resin composition and lower the coefficient of thermal expansion thereof. The component (C) cyanate ester resin is added in an amount of from 16 to 32 parts by weight; e.g. 16, 18, 20, 22, 24, 25, 26, 28, 30 or 32 parts by weight, preferably 16 to 25 parts by weight.

Preferably, the component (C) cyanate ester resin is anyone selected from the group consisting of bisphenol A type cyanate ester resin, bisphenol F type cyanate ester resin, dicyclopentadiene type cyanate ester resin, phenol novolac type cyanate ester resin, and a mixture of at least two selected therefrom.

Preferably, an epoxy resin composition comprises the following components:
(A) from 45 to 54 parts by weight of an epoxy resin containing a DCPD structure;
(B) from 30 to 33 parts by weight of an active ester curing agent; and
(C) from 16 to 25 parts by weight of a cyanate ester resin

Preferably, the epoxy resin composition further comprises a curing accelerator which cures the resin and facilitates the curing rate of the resin. The curing accelerator is added in an amount of from 0.05 to 1 part by weight, based on 100 parts by weight of the sum of the component (A), component (B) and component (C), e.g. 0.08, 0.1, 0.15, 0.2, 0.25, 0.3, 0.35, 0.4, 0.45, 0.5, 0.55, 0.60, 0.65, 0.7, 0.75, 0.8, 0.85, 0.9 or 0.95 parts by weight.

Preferably, the curing accelerator is anyone selected from the group consisting of zinc isooctoate, 4-dimethylaminopyridine, 2-methylimidazole, 2-ethyl-4-methyl-imidazole, 2-phenylimidazole, and a mixture of at least two selected therefrom.

Preferably, the epoxy resin composition further comprises a flame retardant, if necessary, to make the epoxy resin composition have flame retardancy and meet the UL94V-0 requirements. The flame retardant added if necessary is not specifically defined. Preferably, the flame retardant is a bromine-containing flame retardant or/and a halogen-free flame retardant.

The amount of the flame retardant is determined by the requirements that the cured products meet the UL94V-0, and is not specifically defined. Preferably, the flame retardant is added in an amount of 5 to 50 parts by weight, e.g. 5, 10, 15, 25, 30, 35, 40 or 45 parts by weight, based on 100 parts by weight of the sum of the component (A), component (B) and component (C);

Preferably, the bromine-containing flame retardant is anyone selected from the group consisting of decabromodiphenyl ethane, brominated polystyrene, ethylene bistetrabromophthaloyl, bromine-containing epoxy resin, and a mixture of at least two selected therefrom.

Preferably, the halogen-free flame retardant is anyone selected from the group consisting of tri(2,6-dimethylphenyl)phosphine, 10-(2,5-dihydroxyphenyl)-9,10-dihydro-9-oxa-10-phosphaphenanthrene-10-oxide, 2,6-bis(2,6-dimethylphenyl)phosphino-benzene, 10-phenyl-9,10-dihydro-9-oxa-10-phosphaphenanthrene-10-oxide, phenoxy-phosphazene compound, zinc borate, nitrogen-phosphorus intumescent flame retardant, organic polymer halogen-free flame retardant, phosphorus-containing phenolic resin, and a mixture of at least two selected therefrom.

Preferably, the epoxy resin composition further comprises a filler, if necessary. The filler is an organic filler or/and an inorganic filler, which is mainly used to adjust some physical properties of the epoxy resin composition, such as reducing the coefficient of thermal expansion, reducing water absorption rate and improving thermal conductivity.

The amount of the filler is not specifically defined. Preferably, the filler is added in an amount of from 0 to 100 parts by weight, excluding 0, based on 100 parts by weight of the sum of the component (A), component (B) and component (C), preferably from 0 to 50 parts by weight, excluding 0. The filler is added in an amount of, e.g. 0.5, 1, 5, 10, 15, 20, 25, 30, 35, 40, 45, 50, 55, 60, 65, 70, 75, 80, 85, 90 or 95 parts by weight.

Preferably, the inorganic filler is anyone selected from the group consisting of fused silica, crystalline silica, spherical silica, hollow silica, aluminum hydroxide, alumina, talc, aluminum nitride, boron nitride, silicon carbide, barium sulfate, barium titanate, strontium titanate, calcium carbonate, calcium silicate, mica, glass fiber powder, and a mixture of at least two selected therefrom, e.g. the mixture of fused silica and crystalline silica, the mixture of spherical silica and hollow silica, the mixture of aluminum hydroxide and alumina, the mixture of talc and aluminum nitride, the mixture of boron nitride and silicon carbide, the mixture of barium sulfate and barium titanate, the mixture of strontium titanate and calcium carbonate, the mixture of calcium silicate, mica and glass fiber powder, the mixture of fused silica, crystalline silica and spherical silica, the mixture of hollow silica, aluminum hydroxide and alumina, the mixture of talc, and aluminum nitride and boron nitride, the mixture of silicon carbide, barium sulfate and barium titanate, the mixture of strontium titanate, calcium carbonate, calcium silicate, mica and glass fiber powder.

Preferably, the organic filler is anyone selected from the group consisting of polytetrafluoroethylene powder, polyphenylene sulfide, polyether sulfone powder, and a mixture of at least two selected therefrom, e.g. the mixture of polytetrafluoroethylene powder and polyphenylene sulfide, the mixture of polyether sulfone powder and polytetrafluoroethylene powder, the mixture of polytetrafluoroethylene powder, polyphenylene sulfide and polyether sulfone powder.

Preferably, the filler is silica, and the filler has a medium particle size of 1-15 µm, preferably 1-10 µm.

Said expression "comprising/comprise(s)" in the present invention means that, in addition to the components, other components may be included, which impart different properties to the epoxy resin composition. In addition, said "comprising/comprise(s)" described in the present invention may also be replaced by "is/are" or "consisting/consist(s) of" in closed manner.

For example, the epoxy resin composition may also contain various additives, such as antioxidants, heat stabilizers, antistatic agents, ultraviolet absorbers, pigments, colorants or lubricants and the like as specific examples. These various additives may be used separately or in combination of two or more.

The conventional method for preparing the epoxy resin composition glue solution of the present invention comprises: taking a container, putting the solid components first, then adding a solvent, stirring until it is completely dissolved, then adding the liquid resin, filler, flame retardant and curing accelerator, continuing to stir evenly, and finally using a solvent to adjust the solid content of the liquid to 60% to 80%, so as to make a glue solution.

The second object of the present invention is to provide a prepreg comprising a reinforcing material and the epoxy resin composition above attached thereto by impregnation and drying.

Exemplary reinforcing materials comprise non-woven fabrics or/and other fabrics, such as natural fibers, organic synthetic fibers, and inorganic fibers.

The glue solution is used to impregnate the reinforcing material, such as fabrics, e.g. glass fabric, or organic fabrics, and the impregnated reinforcing material is heated and dried in an oven at 155°C for 5 to 10 minutes to obtain a prepreg.

The third object of the present invention is to provide a laminate comprising at least one prepreg above.

The fourth object of the present invention is to provide a printed circuit board, comprising at least one prepreg above.

As compared to the prior art, the present invention has the following beneficial effects.
(1) The present invention discloses adopting an epoxy resin containing a DCPD (dicyclopentadiene) structure in a specific content to improve the glass transition temperature of the epoxy resin composition and reduce the water absorption rate thereof. The active ester curing agent in a specific content can improve the dielectric properties and water absorption performance of the epoxy resin composition. The cyanate ester resin in a specific content can increase the glass transition temperature of the epoxy resin composition and lower the coefficient of thermal expansion thereof. The present invention discloses obtaining the above-mentioned epoxy resin composition by utilizing the mutual cooperation and synergistic effect between the aforesaid three essential components in specific contents. Prepreg, laminate, and printed circuit board made from the epoxy resin composition have low coefficient of thermal expansion, low water absorption, and excellent dielectric properties, on the premise of having high heat and moisture resistance and high heat resistance at the same time, which achieves unexpected technical effects compared to A+B and A+C, and are beneficial to further improving the PCT properties of the composition.
(2) In the epoxy resin composition of the present invention, the epoxy resin containing a DCPD structure satisfies the weight average molecular weight distribution of 200 to 4000, and the proportion of the weight average molecular weight distribution of less than 400 is less than 30 %wt, which is favorable for improving heat and moisture resistance of the epoxy resin composition.

### Embodiments

The technical solution of the present invention is further explained by the following embodiments.

A metal foil-clad laminate made from the epoxy resin composition prepared as described above was tested for glass transition temperature, coefficient of thermal expansion, dielectric loss factor, PCT, and PCT water absorption rate. The following examples were added to the detailed description, wherein the part by weight of the organic resin is based on the part by weight of organic solids.

### Example 1

54 parts by weight of KES-7695 was added to a container, and a suitable amount of MEK was added and stirred until being completely dissolved. Then 30 parts by weight of an active ester curing agent HPC-8000-65T, 16 parts by weight of cyanate ester resin CEOIPS, a curing accelerator DMAP dissolved in advance and zinc isooctoate were added to continue to stir evenly. Finally, a solvent was used to adjust the solid content of the liquid to 60% to 80% to make a glue solution. A glass fiber cloth was impregnated with the glue solution above and controlled to an appropriate thickness. Subsequently, the solvent was dried to obtain a prepreg. A plurality of prepared prepregs were superimposed on each other, and copper foils were pressed on each of both sides of the prepregs separately, placed in a hot press and cured to obtain the epoxy resin-copper clad laminate. The physical property data thereof are shown in Table 1.

### Examples 2 to 4

The manufacturing processes are the same as that in Example 1, and the formulations and physical properties are shown in Table 1.

### Comparison Examples 1 to 13

The manufacturing processes are the same as that of Example 1, and the formulations and physical properties are shown in Table 2 and Table 3.

**Table 1 Formulations and physical property data of each example**

| Formulation | Substance | Example 1 | Example 2 | Example 3 | Example 4 |
|---|---|---|---|---|---|
| Epoxy resin | KES-7695 | 54 | 49 | 38 | 48 |
| Active ester curing agent | HPC-8000-65T | 30 | 30 | 30 | 36 |
| Cyanate ester resin | CE01PS | 16 | 21 | 32 | 16 |
| Curing accelerator | DMAP | q.s. | q.s. | q.s. | q.s. |
| | Zinc iso-ocatanoate | q.s. | q.s. | q.s. | q.s. |
| Performance | Tg | 205 | 215 | 218 | 195 |
| | CTE | 2.60% | 2.40% | 2.40% | 2.80% |
| | Df | 0.0087 | 0.0085 | 0.0083 | 0.0084 |
| | PCT water absorption rate | 0.28% | 0.30% | 0.32% | 0.26% |
| | PCT | 0/3 | 0/3 | 0/3 | 0/3 |

**Table 2 Formulations and physical property data of each comparison example**

| Formulation | Substance | Comp. Example 1 | Comp Example 2 | Comp Example 3 | Comp Example 4 | Comp Example 5 | Comp Example 6 | Comp Example 7 |
|---|---|---|---|---|---|---|---|---|
| Epoxy resin | KES-7695 | | 54 | 56 | 50 | 52 | 56 | |
| | 7200-H | 54 | | | | | | |
| | NC-3000H | | | | | | | 56 |
| Active ester curing agent | HPC-8000-65T | 30 | 25 | 44 | 50 | 10 | 40 | 44 |
| Cyanate ester resin | CE01PS | 16 | 21 | | | 38 | 4 | |
| Curing accelerator | DMAP | q.s. | q.s. | q.s. | | q.s. | q.s. | q.s. |
| | Zinc iso-ocatanoate | q.s. | q.s. | | q.s. | q.s. | q.s. | |
| Performance | Tg | 197 | 220 | 168 | 245 | 230 | 180 | 153 |
| | CTE | 2.70% | 2.30% | 3.40% | 1.90% | 2.10% | 3.40% | 3.60% |
| | Df | 0.0087 | 0.0089 | 0.0102 | 0.0132 | 0.0124 | 0.0092 | 0.007 |
| | PCT water absorption rate | 0.29% | 0.31% | 0.24% | 0.50% | 0.44% | 0.25% | 0.26% |
| | PCT | 3/3 | 3/3 | 0/3 | 3/3 | 3/3 | 0/3 | 0/3 |

**Table 3**

| Formulation | Substance | Comp. Example 8 | Comp. Example 9 | Comp. Example 10 | Comp. Example 11 | Comp. Example 12 | Comp. Example 13 |
|---|---|---|---|---|---|---|---|
| Epoxy resin | KES-7695 | | | 32 | 54 | 64 | 60 |
| | 7200-H | | | | | | |
| | NC-3000H | 50 | 54 | | | 20 | |
| Active ester curing agent | HPC-8000-65T | | 30 | 36 | 36 | | 30 |
| Cyanate ester resin | CE01PS | 50 | 16 | 32 | 10 | 16 | 10 |
| Curing accelerator | DMAP | | q.s. | q.s. | q.s. | q.s. | q.s. |
| | Zinc iso-ocatanoate | q.s. | q.s. | q.s. | q.s. | q.s. | q.s. |
| Performance | Tg | 230 | 185 | 190 | 185 | 225 | 200 |
| | CTE | 2.30% | 2.80% | 3.10% | 3.20% | 2.30% | 2.70% |
| | Df | 0.0100 | 0.0090 | 0.0087 | 0.0089 | 0.0094 | 0.0092 |
| | PCT water absorption rate | 0.52% | 0.28% | 0.34% | 0.25% | 0.30% | 0.27% |
| | PCT | 0/3 | 0/3 | 3/3 | 0/3 | 3/3 | 0/3 |

| | | | | | | | |
|---|---|---|---|---|---|---|---|
| Note: The tables are based on the weight parts of the solid components. | | | | | | | |

The materials listed in Table 1 to Table 3 are as follows.

KES-7695: an epoxy resin containing a DCPD structure (trade name from KOLON), wherein the proportion of the weight-average molecular weight distribution of less than 400 is less than 30% by weight.

7200-H: an epoxy resin containing a DCPD structure (trade name from DIC, Japan), and the proportion of the weight-average molecular weight distribution of less than 400 is more than 30% by weight.

NC-3000H: Biphenyl novolac epoxy resin (Trade Name from Nippon Kayaku).

HPC-8000-65T: Active ester cross-linking agent (trade name from Japan DIC).

CE01PS: Bisphenol A type cyanate ester resin (trade name from Yangzhou Tianqi).

DMAP: A curing accelerator, 4-dimethylaminopyridine (trade name from Guangrong Chemicals).

Zinc isooctanoate: A curing accelerator from Alfa Aesar.

The above characteristics are tested as follows.

Glass transition temperature (Tg): Determined according to the differential scanning calorimetry (DSC) according to the DSC method specified in IPC-TM-650 2.4.25.

Coefficient of Thermal Expansion (CTE): Determined according to the Thermo Mechanical Analyzer (TMA) according to the TMA method specified in IPC-TM-650 2.4.24.6.

Dielectric loss factor: Tested according to the method of IPC-TM-650 2.5.5.13 with a test frequency of 10 GHz.

Evaluation of post-PCT dipping solderability: The copper foil on the surface of the copper clad laminate was etched and the substrate was evaluated. The substrate was placed in a pressure cooker and treated at 120 °C and 105 KPa for 2 h, and then immersed in a tin furnace at 288 °C. When there was stratification and blasting, the corresponding time was recorded. When the substrate had not been bubbled or stratified in the tin furnace for more than 5 min, the evaluation could be ended. If bubbles or stratification occurred in 0, 1, 2, and 3 sheets, they were recorded as 0/3, 1/3, 2/3 and 3/3.

PCT Water Absorption rate: The copper foil on the surface of the copper clad laminate was etched, weighed and recorded as m₁. The substrate was placed in a pressure cooker, removed after treatment at 120 °C and 105 KPa for 2h, immediately weighed after drying the sample with a dry cloth, and recorded m₂. Then PCT water absorption rate % = (m₂-m₁)/m₁^{∗}100%.

### Analysis of physical properties

(1) By comparing Example 1 with Example 4, it can be seen that the glass transition temperature in Example 1 is higher than that in Example 4; the coefficient of thermal expansion in Example 1 is lower than that in Example 4, but the dielectric loss factor and the water absorption rate are higher than those in Example 4. It shows that the increase of the addition amount of the active ester curing agent can reduce the dielectric loss factor and water absorption rate very well, but bring about a decrease in the glass transition temperature and an increase in the coefficient of thermal expansion.
(2) By comparing Example 1 with Example 2 and Example 3, it can be seen that the glass transition temperatures in Examples 2 and 3 are higher than that in Example 1; the coefficients of thermal expansion and dielectric loss factors in Examples 2 and 3 are lower than those in Example 1, but the water absorption rates are higher than that in Example 1. It means that the increase of the addition amount of cyanate ester resin can well improve the glass transition temperature of the composition and reduce the coefficient of thermal expansion and dielectric loss factor of the composition, but will bring about an increase of the water absorption rate.
(3) By comparing Example 1 with Comparison Example 1, it can be seen that the glass transition temperature in Example 1 is higher than that in Comparison Example 1; the coefficient of thermal expansion in Example 1 is lower than that in Comparison Example 1, and the dielectric loss factor and the water absorption rate are substantially the same as those in Comparison Example 1. But the PCT in Comparison Example 1 cannot meet the requirements. It shows that controlling the weight-average molecular weight distribution of less than 400 in the epoxy resin containing a DCPD structure to account for less than 30% by weight is favorable for improving the heat and moisture resistance of the resin composition.
(4) By comparing Examples 1, 2 and 3 with Comparison Example 2, it can be seen that the glass transition temperature in Comparison Example 2 is higher than those in Examples 1, 2 and 3; and the coefficient of thermal expansion in Comparison Example 2 is lower than those in Examples 1, 2 and 3, but its dielectric loss factor and water absorption rate are higher than those in Examples 1, 2 and 3. Moreover, the PCT in Comparison Example 2 cannot satisfy the requirement. It shows that the increase of the addition amount of active ester helps to improving the heat and moisture resistance of the resin composition. When the amount of active ester is added to a certain value, the heat and moisture resistance of the composition still meets the requirements even if the amount of cyanate ester is continuously increased.
(5) By Comparing Example 1 with Comparison Examples 3, 4 and 5, it can be seen that the dielectric loss factor in Example 1 is lower than those in Comparison Examples 3, 4 and 5. However, the dielectric loss factor in Comparison Example 5 is higher than that in Comparison Example 3 but lower than that in Comparison Example 4. In addition, the PCT performances of Comparison Examples 4 and 5 cannot meet the requirements, indicating that controlling the resin proportion of the composition makes unexpected technical effects that the dielectric loss factor of the composition is lower than those of A+B and A+C separately, and is beneficial to further improving the PCT properties of the composition.
(6) By Comparing Examples 1, 2, 3 and 4 with Comparison Example 6, it can be seen that, although the PCT performance in Comparison Example 6 satisfies the requirements, and the water absorption rate thereof is lower than those in Examples 1, 2, 3 and 4, its glass transition temperature is lower than those in Examples 1, 2, 3 and 4; and its coefficient of thermal expansion and dielectric loss factor are higher than those in Examples 1, 2, 3 and 4. It is demonstrated that, by increasing the addition amount of active ester and decreasing the addition amount of cyanate ester, it is beneficial to improving the PCT performance of the composition and reducing its water absorption rate, but brings about a decrease in the glass transition temperature and an increase in the coefficient of thermal expansion and dielectric loss factor.
(7) By comparing Comparison Examples 7, 8 and 9, it can be seen that the dielectric loss factor in Comparison Example 9 is higher than that in Comparison Example 7, but is lower than the dielectric loss factor in Comparison Example 8, which shows that the epoxy resins having different structures have different effects on the dielectric loss factor.
(8) In addition, it can be seen from Examples 1 to 4 and Comparison Examples 2, 5, 6, and 10-13 that only the epoxy resin containing a DCPD structure, active ester curing agent and cyanate ester resin in specific contents can achieve high glass transition temperature, low coefficient of thermal expansion, high heat and moisture resistance, low water absorption rate and low dielectric loss factor.

Therefore, the printed circuit board of the present invention has a high glass transition temperature, a low coefficient of thermal expansion, a high heat and moisture resistance, a low water absorption rate, and a low dielectric loss factor compared with a general laminate.

The applicant claims that the present invention describes the detailed process of the present invention, but the present invention is not limited to the detailed process of the present invention. That is to say, it does not mean that the present invention shall be carried out with respect to the above-described detailed process of the present invention. Those skilled in the art shall know that any improvements to the present invention, equivalent replacements of the raw materials of the present invention, additions of auxiliary, selections of any specific ways all fall within the protection scope and disclosure scope of the present invention.

## Claims

1. An epoxy resin composition comprising the following components:
(A) from 38 to 54 parts by weight of an epoxy resin containing a DCPD structure;
(B) from 30 to 36 parts by weight of an active ester curing agent; and
(C) from 16 to 32 parts by weight of a cyanate ester resin.

2. The epoxy resin composition claimed in claim 1, **characterized in that** the component (A) epoxy resin containing a DCPD structure is added in an amount of from 45 to 54 parts by weight.

3. The epoxy resin composition claimed in any of claims 1 to 2, **characterized in that** the component (B) active ester curing agent is added in an amount of from 30 to 33 parts by weight;
preferably, the component (B) active ester curing agent is obtained by reacting a phenolic compound linked through an alicyclic hydrocarbon structure, a difunctional carboxylic aromatic compound or acid halide and a monohydroxy compound;
preferably, the difunctional carboxylic aromatic compound or acid halide is in an amount of 1mol; the phenolic compound linked through an alicyclic hydrocarbon structure is in an amount of 0.05-0.75mol; the monohydroxy compound is in an amount of 0.25-0.95mol;
preferably, the component (B) active ester curing agent comprises an active ester having the structure of Formula (2) 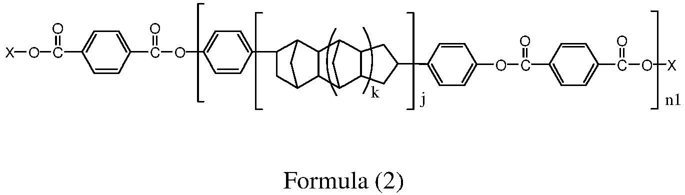 wherein X is phenyl or naphthyl; j is 0 or 1; k is 0 or 1; and n1 represents a repeating unit and is from 0.25 to 1.25.

4. The epoxy resin composition claimed in any of claims 1 to 3, **characterized in that** the component (C) cyanate ester resin is added in an amount of from 16 to 25 parts by weight;
preferably, the component (C) cyanate ester resin is anyone selected from the group consisting of bisphenol A type cyanate ester resin, bisphenol F type cyanate ester resin, dicyclopentadiene type cyanate ester resin, phenol novolac type cyanate ester resin, and a mixture of at least two selected therefrom.

5. The epoxy resin composition claimed in any of claims 1 to 4, **characterized in that** the epoxy resin composition comprises the following components:
(A) from 45 to 54 parts by weight of an epoxy resin containing a DCPD structure;
(B) from 30 to 33 parts by weight of an active ester curing agent; and
(C) from 16 to 25 parts by weight of a cyanate ester resin.

6. The epoxy resin composition claimed in any of claims 1 to 5, wherein the epoxy resin composition further comprises a curing accelerator added in an amount of from 0.05 to 1 part by weight, based on 100 parts by weight of the sum of the component (A), component (B) and component (C);
preferably, the curing accelerator is anyone selected from the group consisting of zinc isooctoate, 4-dimethylaminopyridine, 2-methylimidazole, 2-ethyl-4-methyl-imidazole, 2-phenylimidazole, and a mixture of at least two selected therefrom;
preferably, the epoxy resin composition further comprises a flame retardant; preferably, the flame retardant is a bromine-containing flame retardant or/and a halogen-free flame retardant;
preferably, the flame retardant is added in an amount of 5 to 50 parts by weight, based on 100 parts by weight of the sum of the component (A), component (B) and component (C);
preferably, the bromine-containing flame retardant is anyone selected from the group consisting of decabromodiphenyl ethane, brominated polystyrene, ethylene bistetrabromophthaloyl, bromine-containing epoxy resin, and a mixture of at least two selected therefrom;
preferably, the halogen-free flame retardant is anyone selected from the group consisting of tri(2,6-dimethylphenyl)phosphine, 10-(2,5-dihydroxyphenyl)-9,10-dihydro-9-oxa-10-phosphaphenanthrene-10-oxide, 2,6-bis(2,6-dimethylphenyl)phosphino-benzene, 10-phenyl-9,10-dihydro-9-oxa-10-phosphaphenanthrene-10-oxide, phenoxy-phosphazene compound, zinc borate, nitrogen-phosphorus intumescent flame retardant, organic polymer halogen-free flame retardant, phosphorus-containing phenolic resin , and a mixture of at least two selected therefrom.

7. The epoxy resin composition claimed in any of claims 1 to 6, **characterized in that** the epoxy resin composition further comprises a filler;
preferably, the filler is an organic filler or/and an inorganic filler;
preferably, the filler is added in an amount of from 0 to 100 parts by weight, excluding 0, based on 100 parts by weight of the sum of the component (A), component (B) and component (C), preferably from 0 to 50 parts by weight, excluding 0;
preferably, the inorganic filler is anyone selected from the group consisting of fused silica, crystalline silica, spherical silica, hollow silica, aluminum hydroxide, alumina, talc, aluminum nitride, boron nitride, silicon carbide, barium sulfate, barium titanate, strontium titanate, calcium carbonate, calcium silicate, mica, glass fiber powder, and a mixture of at least two selected therefrom;
preferably, the organic filler is anyone selected from the group consisting of polytetrafluoroethylene powder, polyphenylene sulfide, polyether sulfone powder, and a mixture of at least two selected therefrom.

8. A prepreg comprising a reinforcing material and the epoxy resin composition claimed in any of claims 1 to 7 attached thereto by impregnation and drying.

9. A laminate comprising at least one prepreg claimed in claim 8.

10. A printed circuit board comprising at least one prepreg claimed in claim 8.

## Patentansprüche

1. Epoxidharzzusammensetzung, umfassend die folgenden Komponenten:
(A) 38 bis 54 Gewichtsteile eines Epoxidharzes, das eine DCPD-Struktur enthält;
(B) 30 bis 36 Gewichtsteile eines Aktivester-Härtungsmittels; und
(C) 16 bis 32 Gewichtsteile eines Cyanatesterharzes.

2. Epoxidharzzusammensetzung nach Anspruch 1, **dadurch gekennzeichnet, dass** das Epoxidharz der Komponente (A), das eine DCPD-Struktur enthält, in einer Menge von 45 bis 54 Gewichtsteilen zugegeben wird.

3. Epoxidharzzusammensetzung nach einem der Ansprüche 1 bis 2, **dadurch gekennzeichnet, dass** das Aktivester-Härtungsmittel der Komponente (B) in einer Menge von 30 bis 33 Gewichtsteilen zugegeben wird;
wobei das Aktivester-Härtungsmittel der Komponente (B) vorzugsweise durch Umsetzen einer phenolischen Verbindung, die über eine alicyclische Kohlenwasserstoffstruktur verknüpft ist, einer difunktionellen aromatischen Carboxylverbindung oder eines Säurehalogenids und einer Monohydroxyverbindung erhalten wurde;
wobei die difunktionelle aromatische Carboxylverbindung oder das Säurehalogenid vorzugsweise in einer Menge von 1 mol vorliegt; die phenolische Verbindung, die über eine alicyclische Kohlenwasserstoffstruktur verknüpft ist, in einer Menge von 0,05-0,75 mol vorliegt; und die Monohydroxyverbindung in einer Menge von 0,25-0,95 mol vorliegt;
wobei das Aktivester-Härtungsmittel der Komponente (B) vorzugsweise einen Aktivester mit der Struktur der Formel (2) umfasst 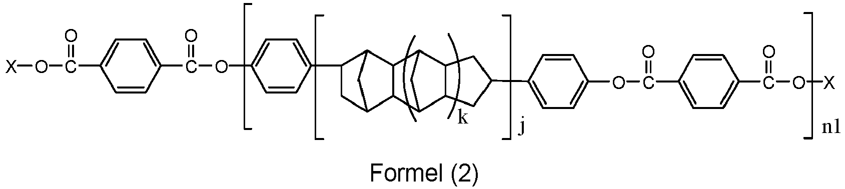 worin X Phenyl oder Naphthyl ist; j 0 oder 1 ist; k 0 oder 1 ist; und n1 eine Wiederholungseinheit darstellt und von 0,25 bis 1,25 beträgt.

4. Epoxidharzzusammensetzung nach einem der Ansprüche 1 bis 3, **dadurch gekennzeichnet, dass** das Cyanatesterharz der Komponente (C) in einer Menge von 16 bis 25 Gewichtsteilen zugegeben wird;
wobei das Cyanatesterharz der Komponente (C) vorzugsweise irgendeines ist, das ausgewählt ist aus der Gruppe bestehend aus Cyanatesterharz vom Bisphenol A-Typ, Cyanatesterharz vom Bisphenol F-Typ, Cyanatesterharz vom Dicyclopentadien-Typ, Cyanatesterharz vom Phenolnovolak-Typ und einer Mischung von mindestens zweien davon.

5. Epoxidharzzusammensetzung nach einem der Ansprüche 1 bis 4, **dadurch gekennzeichnet, dass** die Epoxidharzzusammensetzung die folgenden Komponenten umfasst:
(A) 45 bis 54 Gewichtsteile eines Epoxidharzes, das eine DCPD-Struktur enthält;
(B) 30 bis 33 Gewichtsteile eines Aktivester-Härtungsmittels; und
(C) 16 bis 25 Gewichtsteile eines Cyanatesterharzes.

6. Epoxidharzzusammensetzung nach einem der Ansprüche 1 bis 5, wobei die Epoxidharzzusammensetzung ferner einen Härtungsbeschleuniger umfasst, der in einer Menge von 0,05 bis 1 Gewichtsteilen, bezogen auf 100 Gewichtsteile der Summe der Komponente (A), der Komponente (B) und der Komponente (C), zugegeben wird;
wobei der Härtungsbeschleuniger vorzugsweise irgendeiner ist, der ausgewählt ist aus der Gruppe bestehend aus Zinkisooctoat, 4-Dimethylaminopyridin, 2-Methylimidazol, 2-Ethyl-4-methylimidazol, 2-Phenylimidazol und einem Gemisch von mindestens zweien davon;
wobei die Epoxidharzzusammensetzung vorzugsweise ferner ein Flammschutzmittel umfasst; wobei das Flammschutzmittel vorzugsweise ein bromhaltiges Flammschutzmittel oder/und ein halogenfreies Flammschutzmittel ist;
wobei das Flammschutzmittel vorzugsweise in einer Menge von 5 bis 50 Gewichtsteilen, bezogen auf 100 Gewichtsteile der Summe der Komponente (A),
der Komponente (B) und der Komponente (C), zugesetzt wird;
wobei das bromhaltige Flammschutzmittel vorzugsweise irgendeines ist, das ausgewählt ist aus der Gruppe bestehend aus Decabromdiphenylethan, bromiertem Polystyrol, Ethylenbistetrabromphthaloyl, bromhaltigem Epoxidharz und einer Mischung von mindestens zweien davon;
wobei das halogenfreie Flammschutzmittel vorzugsweise irgendeines ist, das ausgewählt ist aus der Gruppe bestehend aus Tri(2,6-dimethylphenyl)phosphin, 10-(2,5-Dihydroxyphenyl)-9,10-dihydro-9-oxa-10-phosphaphenanthren-10-oxid, 2,6-Bis(2,6-dimethylphenyl)phosphinobenzol, 10-Phenyl-9,10-dihydro-9-oxa-10-phosphaphenanthren-10-oxid, einer Phenoxyphosphazenverbindung, Zinkborat, Stickstoff-Phosphor intumeszierendes Flammschutzmittel, halogenfreiem Flammschutzmittel aus organischem Polymer, phosphorhaltigem Phenolharz und einer Mischung von mindestens zweien davon.

7. Epoxidharzzusammensetzung nach einem der Ansprüche 1 bis 6, **dadurch gekennzeichnet, dass** die Epoxidharzzusammensetzung ferner einen Füllstoff umfasst;
wobei der Füllstoff vorzugsweise ein organischer Füllstoff oder/und ein anorganischer Füllstoff ist;
wobei der Füllstoff vorzugsweise in einer Menge von 0 bis 100 Gewichtsteilen, ausschließlich 0, bezogen auf 100 Gewichtsteile der Summe der Komponente (A), der Komponente (B) und der Komponente (C), zugesetzt wird, vorzugsweise 0 bis 50 Gewichtsteile, ausschließlich 0;
wobei der anorganische Füllstoff vorzugsweise irgendeiner ist, der ausgewählt ist aus der Gruppe bestehend aus Quarzglas, kristallinem Siliciumdioxid, kugelförmigem Siliciumdioxid, hohlem Siliciumdioxid, Aluminiumhydroxid, Aluminiumoxid, Talk, Aluminiumnitrid, Bornitrid, Siliciumcarbid, Bariumsulfat, Bariumtitanat, Strontiumtitanat, Calciumcarbonat, Calciumsilicat, Glimmer, Glasfaserpulver und einer Mischung von mindestens zweien davon;
wobei der organische Füllstoff vorzugsweise irgendeiner ist, der ausgewählt ist aus der Gruppe bestehend aus Polytetrafluorethylenpulver, Polyphenylensulfid, Polyethersulfonpulver und einer Mischung von mindestens zweien davon.

8. Prepreg, umfassend ein Verstärkungsmaterial und die Epoxidharzzusammensetzung nach einem der Ansprüche 1 bis 7, die durch Imprägnieren und Trocknen daran befestigt ist.

9. Laminat, umfassend mindestens ein Prepreg nach Anspruch 8.

10. Leiterplatte, umfassend mindestens ein Prepreg nach Anspruch 8.

## Revendications

1. Composition de résine époxy comprenant les composants suivants :
(A) de 38 à 54 parties en poids d'une résine époxy contenant une structure DCPD ;
(B) de 30 à 36 parties en poids d'un agent de durcissement ester actif ; et
(C) de 16 à 32 parties en poids d'une résine ester de cyanate.

2. Composition de résine époxy selon la revendication 1, **caractérisée en ce que** le composant (A) résine époxy contenant une structure DCPD est ajouté dans une quantité de 45 à 54 parties en poids.

3. Composition de résine époxy selon l'une quelconque des revendications 1 et 2, **caractérisée en ce que** le composant (B) agent de durcissement ester actif est ajouté dans une quantité de 30 à 33 parties en poids ;
de préférence, le composant (B) agent de durcissement ester actif est obtenu par réaction d'un composé phénolique lié par l'intermédiaire d'une structure d'hydrocarbure alicyclique, d'un composé aromatique carboxylique difonctionnel ou d'un halogénure d'acide et d'un composé monohydroxy ;
de préférence, le composé aromatique carboxylique difonctionnel ou halogénure d'acide est dans une quantité de 1 mol ; le composé phénolique lié par le biais d'une structure d'hydrocarbure alicyclique est dans une quantité de 0,05 à 0,75 mol ; le composé monohydroxy est dans une quantité de 0,25 à 0,95 mol ;
de préférence, le composant (B) agent de durcissement ester actif comprend un ester actif répondant à la structure de formule (2) 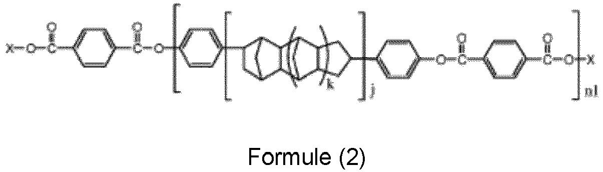 dans laquelle X est phényle ou naphtyle ; j vaut 0 ou 1 ; k vaut 0 ou 1 ; et n1 représente un motif répété et vaut de 0,25 à 1,25.

4. Composition de résine époxy selon l'une quelconque des revendications 1 à 3, **caractérisée en ce que** le composant (C) résine ester de cyanate est ajouté dans une quantité de 16 à 25 parties en poids ;
de préférence, le composant (C) résine ester de cyanate est l'un quelconque choisi dans le groupe consistant en une résine ester de cyanate de type bisphénol A, une résine ester de cyanate de type bisphénol F, une résine ester de cyanate de type dicyclopentadiène, une résine ester de cyanate de type phénol novolaque, et un mélange d'au moins deux choisis entre eux.

5. Composition de résine époxy selon l'une quelconque des revendications 1 à 4, **caractérisée en ce que** la composition de résine époxy comprend les composants suivants :
(A) de 45 à 54 parties en poids d'une résine époxy contenant une structure DCPD ;
(B) de 30 à 33 parties en poids d'un agent de durcissement ester actif ; et
(C) de 16 à 25 parties en poids d'une résine ester de cyanate.

6. Composition de résine époxy selon l'une quelconque des revendications 1 à 5, dans laquelle la composition de résine époxy comprend en outre un accélérateur de durcissement ajouté dans une quantité de 0,05 à 1 partie en poids, rapportée à 100 parties en poids de la somme du composant (A), du composant (B) et du composant (C) ;
de préférence, l'accélérateur de durcissement est l'un quelconque choisi dans le groupe consistant en l'isooctoate de zinc, la 4-diméthylaminopyridine, le 2-méthylimidazole, le 2-éthyl-4-méthyl-imidazole, le 2-phénylimidazole, et un mélange d'au moins deux choisis entre eux ;
de préférence, la composition de résine époxy comprend en outre un retardateur de flammes ; de préférence, le retardateur de flammes est un retardateur de flammes contenant du brome et/ou un retardateur de flammes dépourvu d'halogène ;
de préférence, le retardateur de flammes est ajouté dans une quantité de 5 à 50 parties en poids, rapportée à 100 parties en poids de la somme du composant (A), du composant (B) et du composant (C) ;
de préférence, le retardateur de flammes contenant du brome est l'un quelconque choisi dans le groupe consistant en le décabromodiphényl éthane, le polystyrène bromé, l'éthylène bistétrabromophtaloyle, une résine époxy contenant du brome, et un mélange d'au moins deux éléments choisis entre eux ;
de préférence, le retardateur de flammes dépourvu d'halogène est l'un quelconque choisi dans le groupe consistant en la tri(2,6-diméthylphényl)phosphine, le 10-(2,5-dihydroxyphényl)-9,10-dihydro-9-oxa-10-phosphaphénanthrène-10-oxyde, le 2,6-bis(2,6-diméthylphényl)phosphino-benzène, le 10-phényl-9,10-dihydro-9-oxa-10-phosphaphénanthrène-10-oxyde, un composé phénoxy-phosphazène, le borate de zinc, un retardateur de flammes intumescent à base d'azote-phosphore, un retardateur de flammes dépourvu d'halogène à polymère organique, une résine phénolique contenant du phosphore, et un mélange d'au moins deux éléments choisis entre eux.

7. Composition de résine époxy selon l'une quelconque des revendications 1 à 6, **caractérisée en ce que** la composition de résine époxy comprend en outre une charge ;
de préférence, la charge est une charge organique et/ou une charge inorganique ;
de préférence, la charge est ajoutée dans une quantité de 0 à 100 parties en poids, à l'exclusion de 0, rapportée à 100 parties en poids de la somme du composant (A), du composant (B) et du composant (C), de préférence de 0 à 50 parties en poids, à l'exclusion de 0 ;
de préférence, la charge inorganique est l'une quelconque choisie dans le groupe consistant en la silice fondue, la silice cristalline, la silice sphérique, la silice creuse, l'hydroxyde d'aluminium, l'alumine, le talc, le nitrure d'aluminium, le nitrure de bore, le le carbure de silicium, le sulfate de baryum, le titanate de baryum, le titanate de strontium, le carbonate de calcium, le silicate de calcium, le mica, la poudre de fibre de verre, et un mélange d'au moins deux éléments choisis entre eux ;
de préférence, la charge organique est l'une quelconque choisie dans le groupe consistant en la poudre de polytétrafluoroéthylène, le poly(sulfure de phénylène), la poudre de poly(éther sulfone), et un mélange d'au moins deux éléments choisis entre eux.

8. Pré-imprégné comprenant un matériau de renforcement et la composition de résine époxy revendiquée dans l'une quelconque des revendications 1 à 7 fixée à celui-ci par imprégnation et séchage.

9. Stratifié comprenant au moins un pré-imprégné revendiqué dans la revendication 8.

10. Carte de circuit imprimé comprenant au moins un pré-imprégné revendiqué dans la revendication 8.
